# EUROPEAN PATENT APPLICATION

(11) **EP 4 793 614 A1**
(43) Date of publication of application: **19.08.2026**
(21) Application number: 26151792.4
(22) Date of filing: 14.01.2026
(51) Int. Cl.: G01L 27/00, G01L 19/00, F16K 31/52

(54) **PRESSURE SENSOR CALIBRATION VALVE FOR IMPROVING ZEROING CALIBRATION OF PRESSURE SENSORS**

(30) Priority: 18.02.2025 US 202519056505
(71) Applicant: Honeywell International Inc., Charlotte, NC 28202 (US)
(72) Inventor: WADE, Richard, Charlotte, 28202 (US); PETERS, Jessica, Charlotte, 28202 (US); FURLONG, Gregory, Charlotte, 28202 (US)
(74) Representative: Haseltine Lake Kempner LLP

(57) **Abstract**

Examples of the present application provide pressure sensor calibration valves for improving zeroing calibration of pressure sensors. For example, an example pressure sensor calibration valve includes a valve body having a vent port, a rotatable handle connected to a pinion gear positioned in the valve body, and a sealing component connected to a linear rack that engages with the pinion gear. When the rotatable handle is at a sensing position, the sealing component is biased to seal a vent port opening of the vent port. When the rotatable handle is rotated from the sensing position to a venting position, the sealing component is displaced away from the vent port, and an electrical signal is triggered to initiate the zeroing calibration of the pressure sensor.

## Description

### BACKGROUND OF THE INVENTION

Applicant has identified many technical challenges and difficulties associated with calibrating pressure sensors.

### SUMMARY OF THE INVENTION

Various embodiments described herein relate to example pressure sensor calibration valves. In accordance with various embodiments of the present disclosure, an example pressure sensor calibration valve is provided. In some embodiments, the example pressure sensor calibration valve comprises a valve body comprising a vent port; a rotatable handle connected to a pinion gear positioned in the valve body, and a sealing component connected to a linear rack that engages with the pinion gear.

In some embodiments, the sealing component is biased to seal a vent port opening of the vent port when the rotatable handle is at a sensing position.

In some embodiments, a rotation of the rotatable handle from the sensing position to a venting position causes a displacement of the sealing component away from the vent port opening and triggers an electrical signal that initiates the zeroing calibration of the pressure sensor.

In some embodiments, the electrical signal is transmitted to the pressure sensor.

In some embodiments, the electrical signal is transmitted to a sensor controller that is electrically coupled to the pressure sensor.

In some embodiments, the sealing component is biased to seal the vent port opening of the vent port by a leaf spring.

In some embodiments, the leaf spring is coupled to a spring-actuated switch. In some embodiments, the rotation of the rotatable handle from the sensing position to the venting position activates the spring-actuated switch.

In some embodiments, the pressure sensor calibration valve further comprises a metal plate secured to an end of the linear rack; and an anisotropic magnetresistance (AMR) sensor secured in the valve body.

In some embodiments, the rotation of the rotatable handle from the sensing position to the venting position causes a linear movement of the metal plate that triggers the AMR sensor to generate the electrical signal.

In some embodiments, the linear rack comprises a plurality of rack teeth. In some embodiments, the pinion gear comprises a plurality of gear teeth. In some embodiments, the plurality of gear teeth engages with the plurality of rack teeth.

In some embodiments, the rotation of the rotatable handle causes a rotation of the plurality of gear teeth. In some embodiments, the rotation of the plurality of gear teeth causes a linear movement of the linear rack and the sealing component.

In some embodiments, the valve body further comprises a sensor port and a fluid port.

In some embodiments, the fluid port receives a fluid.

In some embodiments, the sensor port is fluidly connected to the pressure sensor.

In some embodiments, the rotatable handle comprises a handle shaft positioned in the valve body. In some embodiments, the pinion gear is connected to the handle shaft.

In some embodiments, the handle shaft comprises a vent opening, a sensor opening, and a fluid opening. In some embodiments, the vent opening, the sensor opening, and the fluid opening are fluidly connected to one another.

In some embodiments, when the rotatable handle is at the venting position, the sensor port is fluidly connected to the vent port, and the fluid port is fluidly disconnected from the sensor port and the vent port.

In some embodiments, when the rotatable handle is at the venting position: the sensor port of the valve body is aligned with the sensor opening of the handle shaft, and the vent port of the valve body is aligned with the vent opening of the handle shaft.

In some embodiments, when the rotatable handle is at the venting position, the fluid port of the valve body is not aligned with the fluid opening of the handle shaft.

In some embodiments, when the rotatable handle is at the sensing position, the sensor port is fluidly connected to the fluid port, and the vent port is fluidly disconnected from the sensor port and the fluid port.

In some embodiments, when the rotatable handle is at the sensing position: the sensor port of the valve body is aligned with the sensor opening of the handle shaft, and the fluid port of the valve body is aligned with the fluid opening of the handle shaft.

In some embodiments, when the rotatable handle is at the sensing position, the vent port of the valve body is not aligned with the vent opening of the handle shaft.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein.
FIG. 1A is an example isometric view of an example pressure sensor in accordance with some embodiments of the present disclosure.
FIG. 1B is an example cross-section view illustrating the example pressure sensor shown in FIG. 1A in accordance with some embodiments of the present disclosure.
FIG. 2A is an example front view illustrating an example pressure sensor calibration valve in accordance with some embodiments of the present disclosure.
FIG. 2B is an example zoomed view illustrating the example pressure sensor calibration valve shown in FIG. 2A in accordance with some embodiments of the present disclosure.
FIG. 2C is an example cross-section view illustrating the example pressure sensor calibration valve shown in FIG. 2A in accordance with some embodiments of the present disclosure.
FIG. 2D is an example side view illustrating the example pressure sensor calibration valve shown in FIG. 2A in accordance with some embodiments of the present disclosure.
FIG. 2E is an example side view illustrating the example pressure sensor calibration valve shown in FIG. 2A in accordance with some embodiments of the present disclosure.
FIG. 2F is an example side view illustrating the example pressure sensor calibration valve shown in FIG. 2A in accordance with some embodiments of the present disclosure.
FIG. 3A is an example front view illustrating an example pressure sensor calibration valve in accordance with some embodiments of the present disclosure.
FIG. 3B is an example back view illustrating the example pressure sensor calibration valve shown in FIG. 3A in accordance with some embodiments of the present disclosure.
FIG. 3C is an example zoomed view illustrating the example pressure sensor calibration valve shown in FIG. 3A in accordance with some embodiments of the present disclosure.
FIG. 4A is an example front view illustrating an example pressure sensor calibration valve in accordance with some embodiments of the present disclosure.
FIG. 4B is an example circuit diagram illustrating example electronic components of the example pressure sensor calibration valve shown in FIG. 4A in accordance with some embodiments of the present disclosure.
FIG. 5A is an example front view illustrating an example pressure sensor calibration valve in accordance with some embodiments of the present disclosure.
FIG. 5B is an example circuit diagram illustrating example electronic components of the example pressure sensor calibration valve shown in FIG. 5B in accordance with some embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

The term "electronically coupled," "electronically coupling," "electronically couple," "in communication with," "in electronic communication with," or "connected" in the present disclosure refers to two or more elements or components being connected through wired means and/or wireless means, such that signals, electrical voltage/current, data and/or information may be transmitted to and/or received from these elements or components.

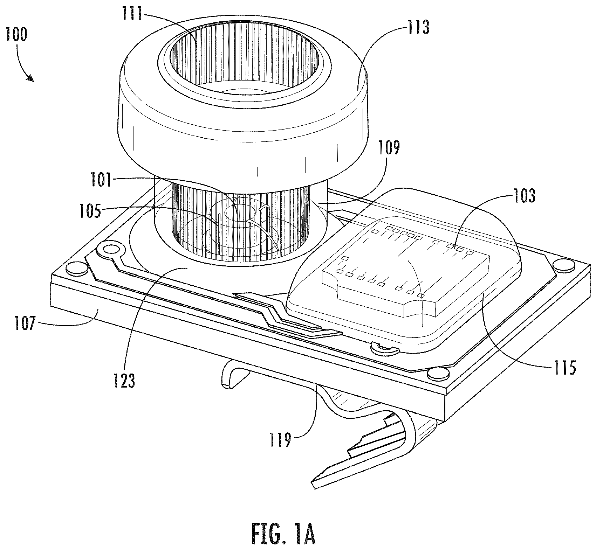

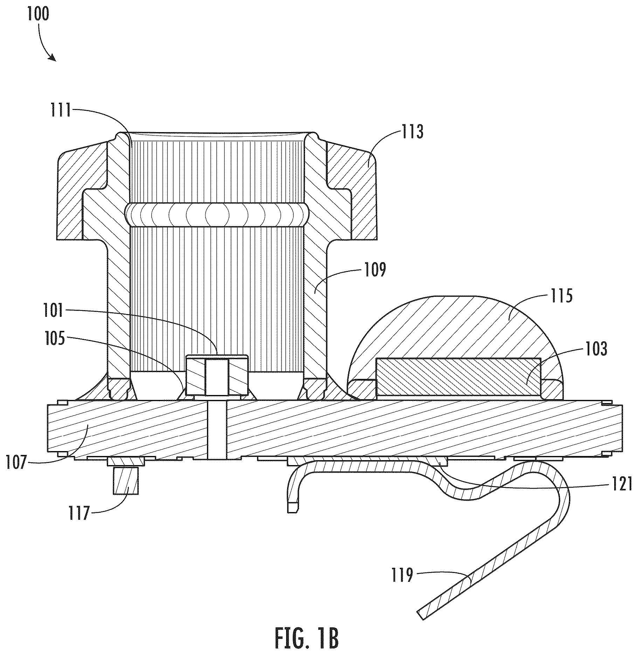

Referring now to FIG. 1A and FIG. 1B, example views associated with an example pressure sensor in accordance with some embodiments of the present disclosure are illustrated. In particular, FIG. 1A is an example isometric view of an example pressure sensor 100, while FIG. 1B is an example cross-section view of the example pressure sensor 100.

In the example shown in FIG. 1A and FIG. 1B, the example pressure sensor 100 comprises a sense die 101 and an Application-Specific Integrated Circuit (ASIC) 103.

In some embodiments, the sense die 101 may be in the form of a pressure sensing die. For example, the sense die 101 may convert detected pressure into an electrical output. Example sense die 101 may include, but not limited to, strain gauge pressure transducers, piezoelectric pressure sensors, and/or the like.

In some embodiments, the ASIC 103 may be programmed to perform one or more functions such as, but not limited to, signal conditioning, linearization, analog-to-digital conversion, and/or the like.

In the examples shown in FIG. 1A and FIG. 1B, both the sense die 101 and the ASIC 103 are secured on a circuit board 107. For example, the sense die 101 and/or the ASIC 103 may be electronically coupled through one or more wire bonds (such as, but not limited to, wire bonds 105). In some embodiments, the wire bonds 105 may comprise materials such as, but not limited to, gold, aluminum, and/or the like.

In accordance with various embodiments of the present disclosure, the example pressure sensor 100 is configured to sense, detect, and/or measure the pressure of a media (such as, but not limited to, fluids, gas, and/or the like). In some embodiments, the example pressure sensor 100 implements one or more features to insulate and protect various electronic components (such as, but not limited to, the sense die 101, the ASIC 103, and/or the like) from being in direct contact with the media.

In the example shown in FIG. 1A and FIG. 1B, the sense die 101 is housed within a gel ring 109. In some embodiments, the gel ring 109 is filled with gel 111 (such as, but not limited to, silicon gels) to protect the sense die 101 from media while transferring pressure from the media to the sense die 101.

In some embodiments, a bottom portion of the gel ring 109 is secured to the circuit board 107 through adhesive 123. In some embodiments, a top portion of the gel ring 109 is secured using a rubber seal 113. In some embodiments, when the example pressure sensor 100 is implemented to detect the pressure of a fluid through a flow port, the rubber seal 113 is removed, and the gel ring 109 is sealed into the flow port through adhesive (for example, by forming an adhesive joint between the gel ring 109 and the flow port).

In some embodiments, a glob 115 is disposed on top of the ASIC 103 to insulate and protect the ASIC 103. In some embodiments, the glob 115 may protect the ASIC 103 from the media. In some embodiments, the glob 115 may comprise materials such as, but not limited to, polymers, ceramics, glasses, and/or the like. In some embodiments, the glob 115 may be replaced with one or more structure elements (such as, but not limited to, a protective cover, a casing, and/or the like) that is installed on the circuit board 107 to house the ASIC 103 and protect the ASIC 103.

In the example shown in FIG. 1A and FIG. 1B, the sense die 101 and the ASIC 103 are secured on a top surface of the circuit board 107. FIG. 1B further illustrates various components that may be secured on a bottom surface of the circuit board 107.

For example, as shown in FIG. 1B, the example pressure sensor 100 may comprise a capacitor 117 that is secured on a bottom surface of the circuit board 107. In some embodiments, the capacitor 117 may be electronically coupled to the sense die 101 and provide a voltage signal to the sense die 101.

In some embodiments, the example pressure sensor 100 comprises terminals 119 that are secured to the circuit board 107 through the solder 121. In some embodiments, the terminals 119 may be in the form of a clip that is configured to secure the example pressure sensor 100 to one or more other components in a pressure sensing system.

In some embodiments, the top surface of the circuit board 107 (where the sense die 101 and the ASIC 103 are secured) is opposite to the bottom surface of the circuit board 107 (where the capacitor 117 and the terminals 119 are secured).

The example pressure sensor 100 shown in FIG. 1A and FIG. 1B can be implemented in a variety of environments to sense, detect, and/or measure the pressure of a media. For example, the example pressure sensor 100 may be implemented to detect, measure, and/or monitor blood pressure (such as, but not limited to, for invasive blood pressure monitoring in surgery, critical care, and/or other medical settings).

In the example of invasive blood pressure monitoring, a catheter is inserted into one or more arteries of a patient and is fluidly connected to the example pressure sensor 100 through one or more tubing. In some embodiments, the tubing is filled with fluids (such as, but not limited to, saline solution) that transfer pressure from the blood in the one or more arteries to the top of the sense die 101 of the example pressure sensor 100. In such an example, the sense die 101 of the example pressure sensor 100 may directly measure the blood pressure. As blood pumps through the one or more arteries of the patient, the blood exerts pressure on the column of the fluids in the one or more tubing, which in turn transfer the pressure to the sense die 101 of the example pressure sensor 100. As such, the sense die 101 of the example pressure sensor 100 may generate an electrical signal (for example, a voltage signal) that is proportional to the blood pressure.

However, there are many technical challenges and difficulties associated with pressure sensing such as those associated with calibrating pressure sensors (such as, but not limited to, zeroing calibration of pressure sensors).

In the present disclosure, the term "zeroing calibration" refers to the process of calibrating a pressure sensor to set a baseline point (or a reference point) in the output signal for pressure measurement. In implementations such as, but not limited to, invasive blood pressure monitoring described above, the baseline point is the atmospheric pressure. In such examples, a zeroing calibration of the pressure sensor refers to the process of calibrating the pressure sensor so as to record an electrical signal from the pressure sensor that corresponds to the atmospheric pressure. In other words, after a zeroing calibration of the pressure sensor is completed, the pressure sensor should output a reading of zero mmHg when exposed to atmospheric pressure.

Zeroing calibration is often required to be performed as a part of manufacturing and/or initial set-up of pressure sensors. After pressure sensors are used to measure pressure, signal drift may occur and pressure reading may be inaccurate, resulting in the need for zeroing calibration. In the example of blood pressure monitoring, due to the influence of gravity, changes in the relative height between the pressure sensor and the heart of the patient can cause signal drift in offset voltage, and even a little signal drift can change the pressure reading. For example, a change as little as 0.25 inches (6.35 mm) can result in a pressure reading of 114/76 mmHg when the actual pressure is 120/80 mmHg.

As such, ensuring that readings from pressure sensors are as accurately as possible is the goal of this atmospheric "zeroing" calibration. For blood pressure transducers, the standard ANSI/AAMI BP22 allows the drift to be a range of ± 20 mmHg. In practice, the drift needs to be below 1 mmHg over eight hours to avoid having to run the zeroing calibration process too frequently. Continuing from the invasive blood pressure monitoring example, many hospitals require nurses to perform zeroing calibration of pressure sensors every eight hours for each patient or when a nurse changes shift. The zeroing calibration process often requires the nurse to perform at least the following five steps that include the following: rotating a flow valve to turn off the flow of fluid in the tubing to the patient, removing a sterile vent port cap from the tubing so that the pressure sensor is fluidly connected to the atmospheric pressure, selecting the zeroing function on a monitor that is connected to the pressure sensor so as to trigger zeroing of the pressure sensor, reinstalling the sterile vent port cap back on the tubing, and rotating the flow valve back to turn on the flow of fluid in the tubing to the patient. Such a zeroing calibration process can be very time consuming. For example, assuming that each pressure sensor has an estimated lifespan of 96 hours and that each pressure sensor must be zeroed every 8 hours, then each pressure sensor needs to be zeroed 12 times during its lifespan. There is an estimated number of 35 million pressure sensors that are in use for invasive blood pressure monitoring each year. Based on such estimates, 420 million zeroing calibrations must be performed each year. Because many zeroing calibration systems and methods require time-consuming steps to be performed (for example, requiring at least five steps as described above), the efficiency of nurses in providing patient care can be negatively impacted.

In addition, many zeroing calibration systems and methods come with a high risk of catastrophic outcome in case of human error. In the example of invasive blood pressure monitoring, if steps of zeroing calibration of pressure sensors are performed out of the order, the atmospheric pressure may be exerted directly on one or more arteries of the patient. As another example, if the vent port cap is not properly replaced or sterilized, viruses and/or bacteria may enter the patient's body and cause life-threatening infections.

Various embodiments of the present disclosure overcome technical challenges and difficulties associated with zeroing calibration of pressure sensors, and provide various technical improvements and advantages. For example, various embodiments of the present disclosure provide example pressure sensor calibration valves that facilitate and improve zeroing calibration of pressure sensors.

In some embodiments, instead of a sterile vent port cap, an example pressure sensor calibration valve utilizes a sealing component (such as, but not limited to, a silicone ball) that is biased to seal the vent port opening of the vent port, thereby eliminating the need to remove the sterile vent port cap before zeroing calibration begins and eliminating the need to reinstall the sterile vent port after the zeroing calibration is completed.

In some embodiments, an example pressure sensor calibration valve comprises a rotatable handle that is configured to be rotated to a plurality of positions that includes a venting position and a sensing position. For example, when the rotatable handle is at the sensing position, the fluids in the tubing flows to the pressure sensor and the sealing component seals the vent port, such that the pressure sensor may detect, measure, and/or monitor the blood pressure. After the rotatable handle is rotated from the sensing position to the venting position, the rotatable handle causes the sealing component to be displaced from the vent port, such that the vent ported is open and fluidly connected to the pressure sensor, while the fluids in the tubing do not flow to the pressure sensor.

In some embodiments, when the rotatable handle is rotated from the sensing position to the venting position, an electrical signal is triggered and transmitted to the pressure sensor (or a monitor, a sensor controller, and/or a cable that is connected to the pressure sensor) to initiate the zeroing calibration of the pressure sensor.

As illustrated above, rotating the rotatable handle in example pressure sensor calibration valves in accordance with some embodiments of the present disclosure not only connects pressure sensors to atmospheric pressure, but also triggers the zeroing calibration of pressure sensors, thereby reducing steps required for zeroing calibration. For example, in the context of invasive blood pressure monitoring, a nurse may only need to rotate the rotatable handle to the venting position, wait for a second or two, and then rotate the rotatable handle back to the sensing position. As such, various embodiments of the present disclosure provide technical benefits and advantages such as, but not limited to, improving efficiency in zeroing calibration of pressure sensors while reducing risks associated with improper steps being performed for zeroing calibration. Additional details associated with example embodiments of the present disclosure are described in further details herein.

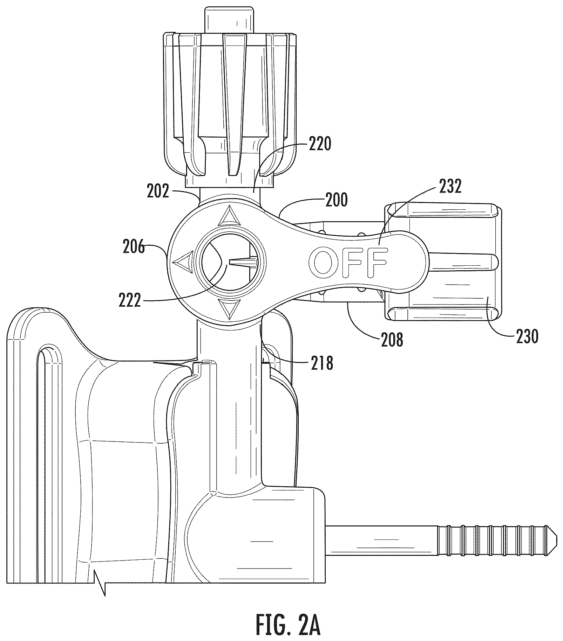

Referring now to FIG. 2A to FIG. 2F, example views associated with an example pressure sensor calibration valve 200 in accordance with some embodiments of the present disclosure are illustrated.

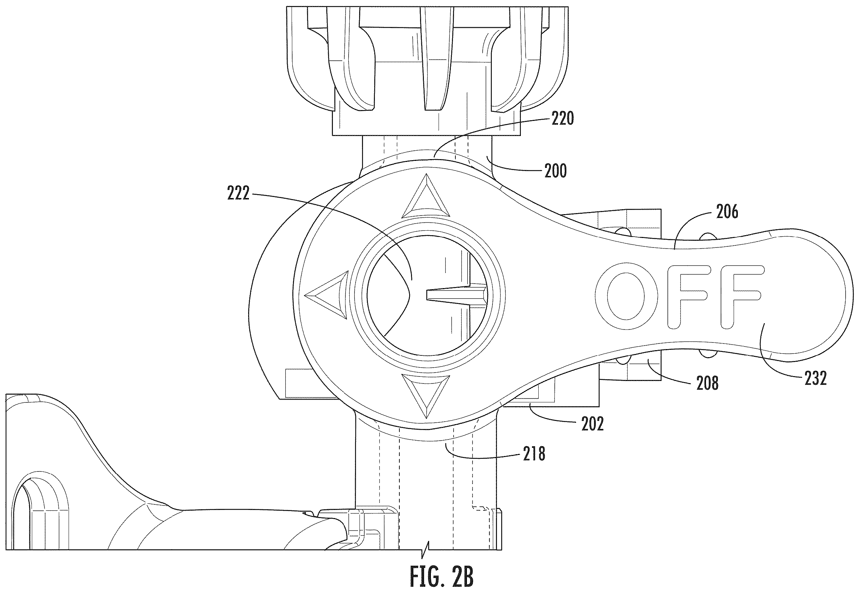

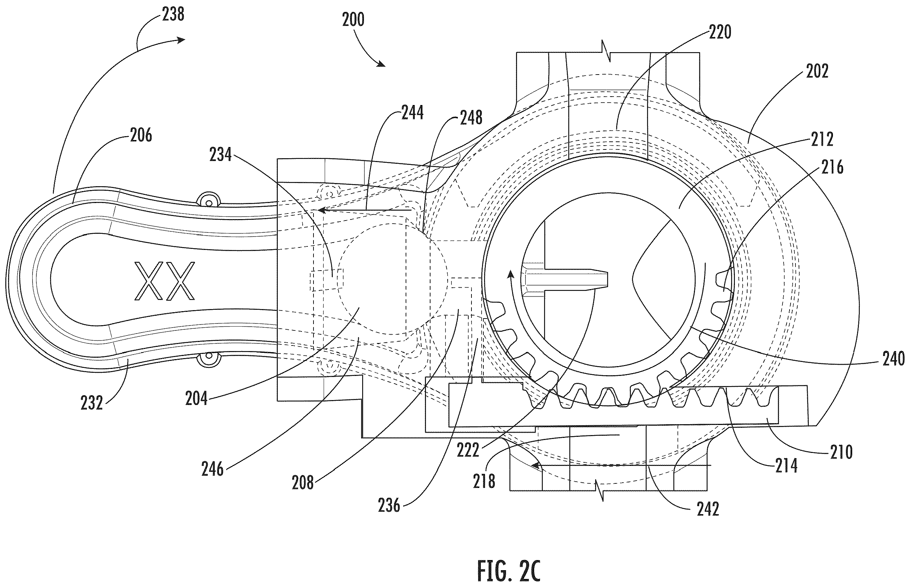

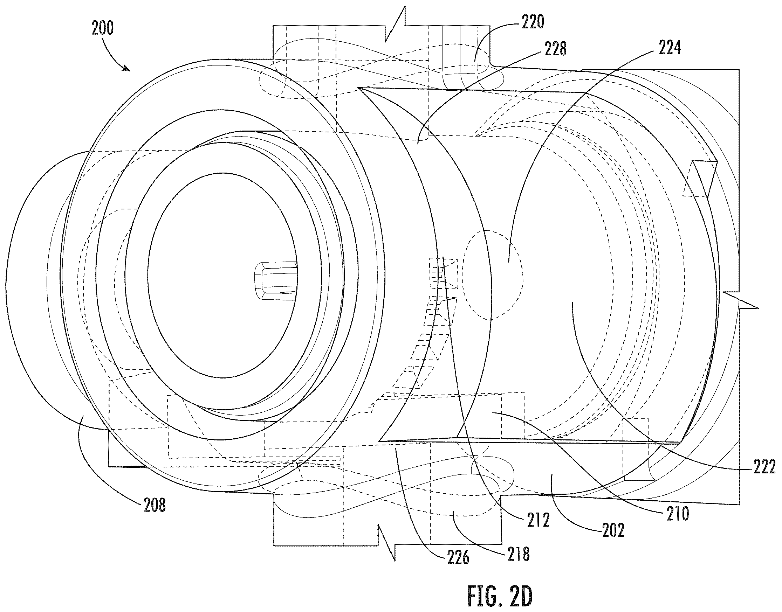

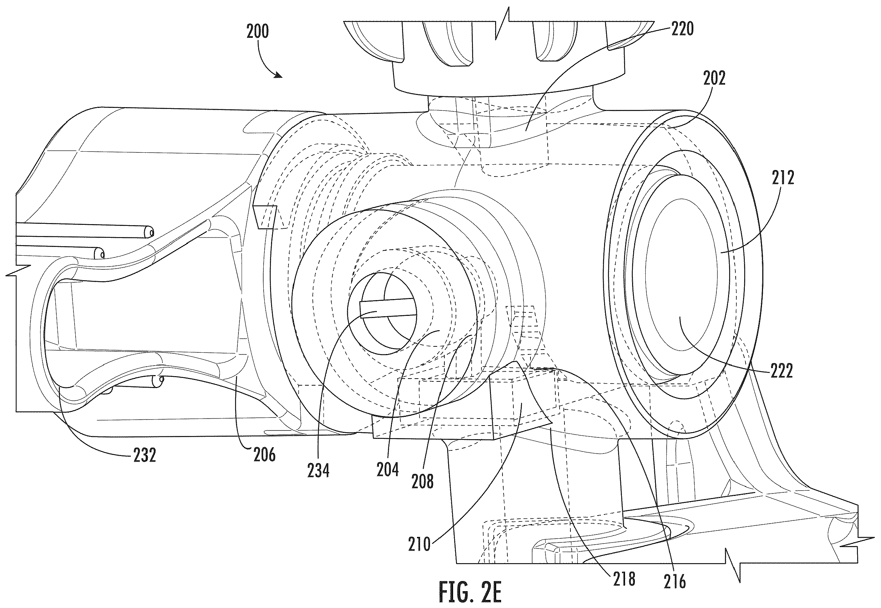

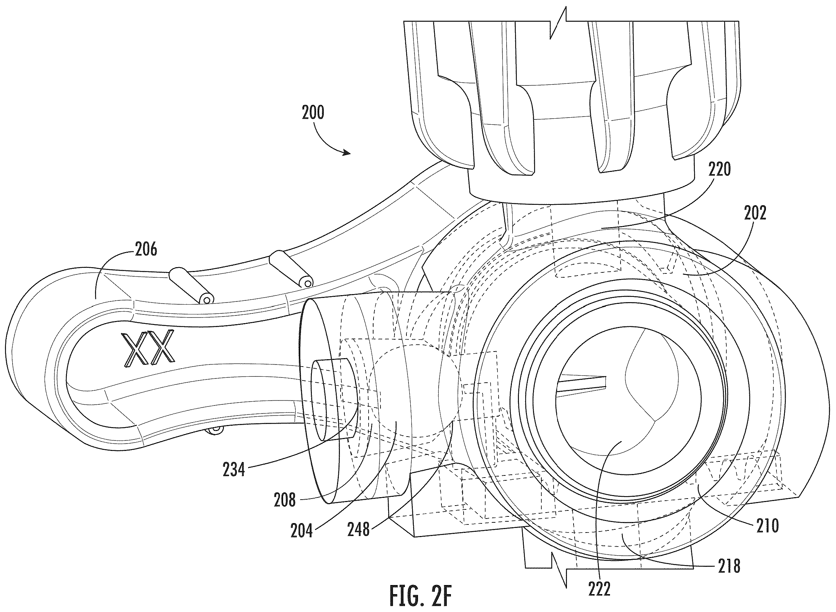

In particular, FIG. 2A is an example front view illustrating an example pressure sensor calibration valve 200. FIG. 2B is an example zoomed view illustrating the example pressure sensor calibration valve 200 shown in FIG. 2A. FIG. 2C is an example cross-section view illustrating the example pressure sensor calibration valve 200. FIG. 2D, FIG. 2E, and FIG. 2F are example side views illustrating the example pressure sensor calibration valve 200.

It should be noted that certain components in FIG. 2C to FIG. 2F are illustrated as being transparent or semi-transparent in order to illustrate and highlight various features in accordance with some embodiments of the present disclosure. In some embodiments, such components may be not constructed as transparent or semi-transparent.

Referring now to FIG. 2A to FIG. 2B, the pressure sensor calibration valve 200 comprises a valve body 202 and a rotatable handle 206.

In some embodiments, the valve body 202 comprises a valve cavity. In some embodiments, the valve cavity is in the form of a center chamber in the valve body 202 that serves as a junction connecting different ports of the valve body 202. In some embodiments, each port of the valve body 202 is connected to the valve cavity and comprises an opening that is connected to the valve cavity. For example, the valve body 202 may comprise a fluid port 220, a sensor port 218, and a vent port 208. In such an example, the fluid port 220, the sensor port 218, and the vent port 208 are each connected to the valve cavity of the valve body 202.

In some embodiments, the sensor port 218 is positioned at a bottom portion of the valve body 202. In some embodiments, the sensor port 218 is fluidly connected to a pressure sensor (such as, but not limited to, the example pressure sensor 100 described above in connection with FIG. 1A and FIG. 1B). For example, a tubing may comprise a first end that is connected to the sensor port 218 of the valve body 202 and a second end that is connected to a flow port. In such an example, the pressure sensor may be secured to the flow port through adhesive as described above, and the tubing provides a fluid passageway from the sensor port 218 to the pressure sensor. Additional details of the sensor port 218 are illustrated in connection with at least FIG. 2C to FIG. 2F.

In some embodiments, the fluid port 220 is positioned at a top portion of the valve body 202. In some embodiments, the fluid port 220 receives a fluid from the top portion of the valve body 202. In the invasive blood pressure monitoring example described above, the fluid port 220 receives the column of the fluids in the tubing (such as, but not limited to, saline solution) that transfers pressure from the blood in a patient. Additional details of the fluid port 220 are illustrated in connection with at least FIG. 2C to FIG. 2F.

In some embodiments, an additional valve (separated from the pressure sensor calibration valve 200) is connected to the top of the fluid port 220 to isolate the pressure sensor from the patient. In such an example, during zeroing calibration, a user may first close the additional valve, and then rotate the rotatable handle 206 of the pressure sensor calibration valve 200 to a venting position. After zeroing calibration is completed, the user may rotate the rotatable handle 206 to a sensing position, and then open the additional valve. Additional details of zeroing calibration are described herein.

In some embodiments, the vent port 208 is positioned at a side portion of the valve body 202. In some embodiments, when the example pressure sensor calibration valve 200 is not in use, a vent port cap 230 may be secured to the valve body 202 to cover and protect the vent port 208. In some embodiments, when the example pressure sensor calibration valve 200 is in use, the vent port cap 230 is removed, and the vent port 208 provides a vent port opening that can be exposed to the external environment so that the pressure at the vent port 208 is the atmospheric pressure. In some embodiments, a sealing element may be biased to seal a vent port opening of the vent port 208 when the pressure sensor is not in zeroing calibration. Additional details of the vent port 208 and the sealing element are illustrated in connection with at least FIG. 2C and FIG. 2F.

Referring back to the examples shown in FIG. 2A and FIG. 2B, the rotatable handle 206 comprises a handle grip 232 and a handle shaft 222.

In some embodiments, the handle grip 232 is a portion of the rotatable handle 206 that is positioned outside the valve body 202. In some embodiments, a user may place his or her hand to hold the handle grip 232 of the rotatable handle 206 and rotate the rotatable handle 206. In some embodiments, the handle grip 232 is shaped to provide comfort to the user's hand when it grips the handle grip 232. In some embodiments, the handle grip 232 comprises an anti-slip surface so that the user can apply force to rotate the rotatable handle 206 without slipping.

In some embodiments, the handle shaft 222 is a portion of the rotatable handle 206 that is positioned in valve body 202. In some embodiments, the handle shaft 222 may be in a shape similar to an elongated cylindrical shape. In some embodiments, the longitudinal axis of the handle shaft 222 is aligned with a rotational axis of the handle grip 232. Additional details of the handle shaft 222 are illustrated in connection with at least FIG. 2C to FIG. 2F.

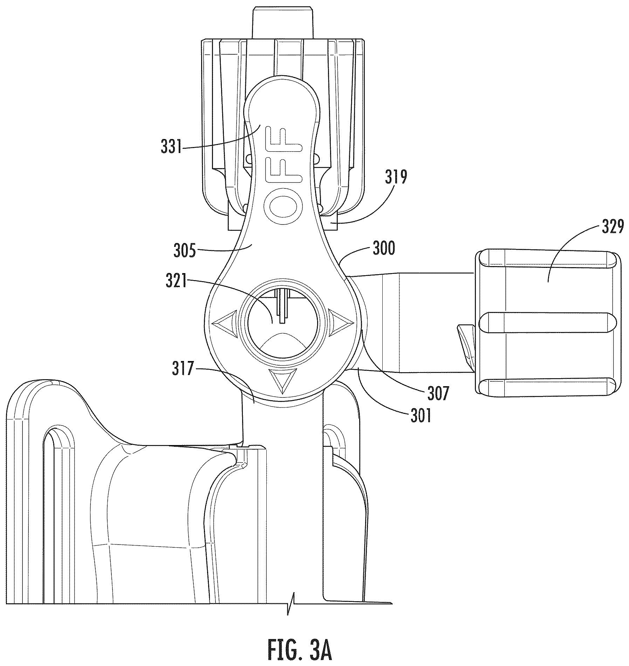

In some embodiments, the handle shaft 222 is connected to the handle grip 232 and rotates when a force is applied to rotate the handle grip 232 of the rotatable handle 206. In some embodiments, the rotatable handle 206 is rotatable to a plurality of positions. In some embodiments, the plurality of positions of the rotatable handle 206 may comprise a venting position and a sensing position. For example, FIG. 2A to FIG. 2F illustrate the example rotatable handle 206 at the sensing position (for example, when the handle grip of the rotatable handle is orientated in parallel with the vent port of the pressure sensor calibration valve), while FIG. 3A to FIG. 3C illustrate an example rotatable handle at the venting position (for example, when the handle grip of the rotatable handle is orientated in parallel with the fluid port of the pressure sensor calibration valve).

In some embodiments, a user may position his or her hand on the handle grip of the rotatable handle and apply force to rotate the rotatable handle from the sensing position to the venting position. For example, a user may apply force to rotate the handle grip of the rotatable handle shown in FIG. 2A to FIG. 2F to switch the rotatable handle from the sensing position to the venting position as shown in FIG. 3A to FIG. 3C.

In some embodiments, when the rotatable handle is at the sensing position, the sensor port is fluidly connected to the fluid port, and the vent port is fluidly disconnected from the sensor port and the fluid port. In some embodiments, when the rotatable handle is at the venting position, the sensor port is fluidly connected to the vent port, and the fluid port is fluidly disconnected from the sensor port and the vent port. Additional details associated with the sensing position and venting position are described herein.

As described above, the rotatable handle 206 comprises the handle shaft 222 that is positioned in the valve body 202. Referring now to FIG. 2C and FIG. 2D, example views of the example pressure sensor calibration valve 200 showing the handle shaft 222 in the valve body 202 are provided. In particular, FIG. 2C illustrates an example cross section back view of the example pressure sensor calibration valve 200 that comprises the valve body 202, the rotatable handle 206, and a sealing component 204.

As described above in connection with FIG. 2A to FIG. 2B, the valve body 202 comprises the vent port 208. In the example shown in FIG. 2C, the sealing component 204 is positioned in the vent port 208 and moveable to seal and unseal a vent port opening 248 of the vent port 208 as a result of the position of the rotatable handle 206.

In some embodiments, the sealing component 204 may be in a shape similar to a sphere shape. In some embodiments, the diameter of the sealing component 204 is larger than the diameter of the vent port opening 248 of the vent port 208 to provide sealing of the vent port 208. In some embodiments, the sealing component 204 may comprise materials such as, but not limited to, silicone, elastomers, plastics, polymers, steel, and/or the like. In some embodiments, the sealing component 204 may comprise a silicone ball.

In some embodiments, the example pressure sensor calibration valve 200 comprises a leaf spring 234 that biases and presses the sealing component 204 towards the vent port opening 248. When the rotatable handle is at the sensing position, the sealing component 204 is biased by the leaf spring 234 to cover and seal the vent port opening 248 of the vent port 208.

In some embodiments, the leaf spring 234 comprises a first end and a second end. In some embodiments, the first end is opposite to the second end. In some embodiments, the first end of the leaf spring 234 is secured to an inner surface of vent port 208 of the valve body 202. In some embodiments, the second end of the leaf spring 234 is secured to an outer surface of the sealing component 204.

In some embodiments, the leaf spring 234 is initially compressed when manufacturing the example pressure sensor calibration valve 200. For example, during manufacturing of the example pressure sensor calibration valve 200, the sealing component 204 is positioned in the vent port chamber 246 of the vent port 208. Subsequently, while the leaf spring 234 is compressed, the second end of the leaf spring 234 is secured to the outer surface of the sealing component 204, and the first end of the leaf spring 234 is secured to the inner surface of vent port 208 of the valve body 202. Because the leaf spring 234 has a natural tendency to return to the uncompressed state, the leaf spring 234 exerts force on the sealing component 204 and presses the sealing component 204 against the vent port opening 248 of the vent port 208. As such, the sealing component 204 is biased to seal the vent port opening 248 of the vent port 208 of the valve body 202.

While the description above provides an example of leaf spring biasing the sealing component to seal the vent port, it is noted that the scope of the present disclosure is not limited to the description above. In some examples, an example pressure sensor calibration valve may comprise one or more additional and/or alternative components (such as, but not limited to, magnetic components) that press and/or bias the sealing component towards the vent port opening of the vent port.

In some embodiments, the sealing component 204 is connected to a linear rack 210. For example, as shown in FIG. 2C, the sealing component 204 is connected to the linear rack 210 through a connection bridge 236. In some embodiments, the linear rack 210 comprises a plurality of rack teeth 214 that is arranged along a length of the linear rack 210.

In some embodiments, the rotatable handle 206 is connected to a pinion gear 212. For example, as shown in FIG. 2C, the handle shaft 222 of the rotatable handle 206 comprises the pinion gear 212. In some embodiments, the pinion gear 212 comprises a plurality of gear teeth 216 that is arranged along an external circumference of the handle shaft 222.

In some embodiments, both the linear rack 210 and the pinion gear 212 are positioned in the valve body 202. For example, both the linear rack 210 and the pinion gear 212 may be positioned in the valve cavity described above.

In some embodiments, the pinion gear 212 engages with the linear rack 210 such that a rotation of the rotatable handle 206 from the sensing position (as shown in FIG. 2C) to a venting position causes movements of the sealing component 204 (for example, a displacement of the sealing component 204 away from the vent port opening 248 of the vent port 208).

For example, as shown in FIG. 2C, a rotation of the rotatable handle 206 in the direction as shown by the arrow 238 causes a rotation of the plurality of gear teeth 216 of the pinion gear 212 in the direction as shown by the arrow 240. In some embodiments, the plurality of gear teeth 216 of the pinion gear 212 engages with the plurality of rack teeth 214 of the linear rack 210. As such, the rotation of the plurality of gear teeth 216 in the direction as shown by the arrow 240 causes a linear movement of the linear rack 210 in the direction as shown by the arrow 242. Continuing in this example, the linear movement of the linear rack 210 in the direction as shown by the arrow 242 exerts a force on the sealing component 204 in the direction as shown by the arrow 244 because the sealing component 204 is connected to the linear rack 210 through the connection bridge 236. In some embodiments, the force exerted on the sealing component 204 by the linear rack 210 through the connection bridge 236 compresses the leaf spring 234 and causes the sealing component 204 to be pushed away from the vent port opening 248 of the vent port 208. As such, the vent port opening 248 is unsealed.

Referring now to FIG. 2D, an example side view of the example pressure sensor calibration valve 200 is illustrated.

As shown in FIG. 2D, the example rotatable handle 206 comprises the handle shaft 222 that is positioned in the valve body 202 of the example pressure sensor calibration valve 200. In some embodiments, the handle shaft 222 comprises a handle cavity. In some embodiments, the handle cavity is in the form of a center chamber in the handle shaft 222 that serves as a junction connecting different openings of the handle shaft 222. In some embodiments, each opening of the handle shaft 222 is connected to the handle cavity.

In the example, the handle shaft 222 of the rotatable handle 206 comprises a vent opening 224, a sensor opening 226, and a fluid opening 228. In some embodiments, the vent opening 224, the sensor opening 226, and the fluid opening 228 are fluidly connected to one another through the handle cavity.

Referring now to FIG. 2E and FIG. 2F, example side views of the example pressure sensor calibration valve 200 are illustrated. In particular, FIG. 2E and FIG. 2F illustrate the flow passageway in the example pressure sensor calibration valve 200 when the rotatable handle 206 of the example pressure sensor calibration valve 200 is in the sensing position.

As described above in connection with FIG. 2A to FIG. 2D, the valve body 202 of the example pressure sensor calibration valve 200 comprises the fluid port 220, the sensor port 218, and the vent port 208. As described above in connection with FIG. 2D, the handle shaft 222 of the rotatable handle 206 comprises a vent opening 224, a sensor opening 226, and a fluid opening 228 that are connected to the handle cavity in the handle shaft 222.

In some embodiments, when the rotatable handle 206 is at the sensing position, the sensor port 218 is fluidly connected to the fluid port 220, and the vent port 208 is fluidly disconnected from the sensor port 218 and the fluid port 220.

For example, when the rotatable handle 206 is at the sensing position as shown in FIG. 2A to FIG. 2F, the sensor port 218 of the valve body 202 is aligned with the sensor opening 226 of the handle shaft 222, and the fluid port 220 of the valve body 202 is aligned with the fluid opening 228 of the handle shaft 222. As such, in the example of invasive blood pressure monitoring, the column of the fluids in the tubing may flow through the fluid port 220 and the fluid opening 228 of the handle shaft 222, then flow through the handle cavity of the handle shaft 222, then exit the handle cavity through the sensor opening 226 of the handle shaft 222, and then enter the tubing connecting the sensor port 218 of the valve body 202 to a pressure sensor. As such, the pressure sensor may detect a pressure from the fluids and/or blood pressure.

In some embodiments, when the rotatable handle 206 is at the sensing position as shown in FIG. 2A to FIG. 2F, the vent port 208 of the valve body 202 is not aligned with the vent opening 224 of the handle shaft 222. For example, as shown in FIG. 2D, when the rotatable handle 206 is at the sensing position, the vent opening 224 of the handle shaft 222 is positioned on an opposite side of the example pressure sensor calibration valve 200 as compared to that of the vent opening 224 of the handle shaft 222. In some embodiments, the pressure sensor calibration valve 200 provides sufficient fit between the valve body 202 and the handle shaft 222 such that atmospheric pressure does not leak into the example pressure sensor calibration valve 200 when the vent port 208 of the valve body 202 is not aligned with the vent opening 224 of the handle shaft 222. Additionally, as described in connection with at least FIG. 2C, the leaf spring 234 presses the sealing component 204 to seal the vent port opening 248 of the vent port 208 when the rotatable handle 206 is at the sensing position, providing a redundant insurance that atmospheric pressure does not leak into the example pressure sensor calibration valve 200 when the rotatable handle 206 is at the sensing position.

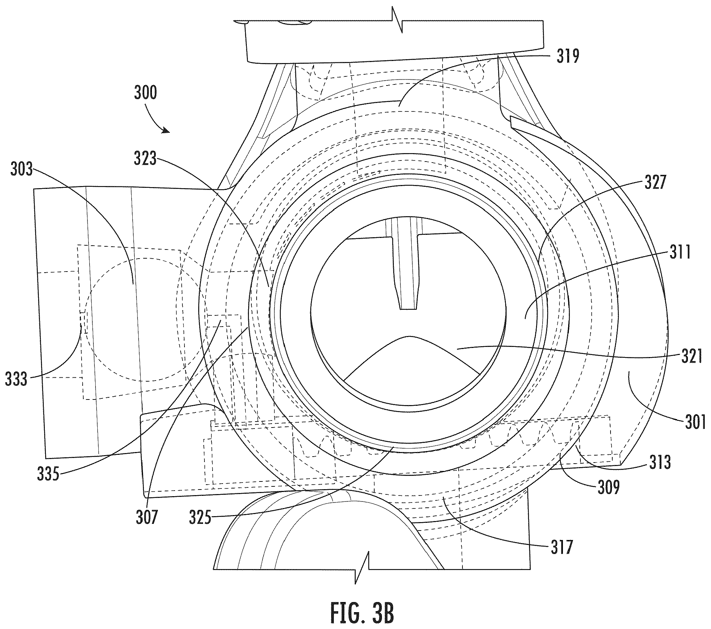

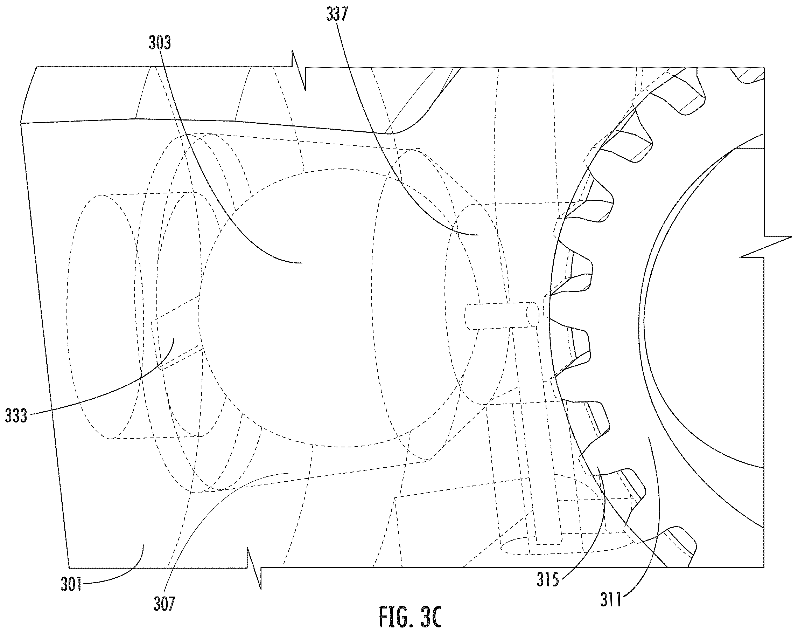

Referring now to FIG. 3A to FIG. 3C, example views associated with an example pressure sensor calibration valve 300 in accordance with some embodiments of the present disclosure are illustrated. In particular, FIG. 3A is an example front view illustrating an example pressure sensor calibration valve 300 in accordance with some embodiments of the present disclosure. FIG. 3B is an example back view illustrating the example pressure sensor calibration valve 300 shown in FIG. 3A in accordance with some embodiments of the present disclosure. FIG. 3C is an example zoomed view illustrating the example pressure sensor calibration valve 300 shown in FIG. 3A in accordance with some embodiments of the present disclosure.

It should be noted that certain components in FIG. 3B are FIG. 3C are illustrated as being transparent or semi-transparent in order to illustrate and highlight various features in accordance with some embodiments of the present disclosure. In some embodiments, such components may be not constructed as transparent or semi-transparent.

Referring now to FIG. 3A, the pressure sensor calibration valve 300 comprises a valve body 301 and a rotatable handle 305.

Similar to the examples described above in connection with FIG. 2A to FIG. 2F, the valve body 301 comprises a valve cavity. In some embodiments, the valve cavity is in the form of a center chamber in the valve body 301 that serves as a junction connecting different ports of the valve body 301. In some embodiments, each port of the valve body 301 is connected to the valve cavity and comprises an opening connected to the valve cavity.

For example, the valve body 301 may comprise a fluid port 319, a sensor port 317, and a vent port 307. In such an example, the fluid port 319, the sensor port 317, and the vent port 307 are each connected to the valve cavity of the valve body 301.

Similar to the fluid port 220 described above in connection with FIG. 2A to FIG. 2F, the fluid port 319 shown in FIG. 3A is positioned at a top portion of the valve body 301. In some embodiments, the fluid port 319 receives a fluid from the top portion of the valve body 301. For example, in the invasive blood pressure monitoring example described above, the fluid port 319 receives the column of the fluids in the tubing that transfers blood pressure.

Similar to the sensor port 218 described above in connection with FIG. 2A to FIG. 2F, the sensor port 317 shown in FIG. 3A is positioned at a bottom portion of the valve body 301. In some embodiments, the sensor port 317 is fluidly connected to a pressure sensor (such as, but not limited to, the example pressure sensor 100 described above in connection with FIG. 1A and FIG. 1B). For example, a tubing connects the sensor port 317 of the valve body 301 to the pressure sensor and provides a fluid passageway from the sensor port 317 to the pressure sensor.

Similar to the vent port 208 described above in connection with FIG. 2A to FIG. 2F, the vent port 307 shown in FIG. 3A is positioned at a side portion of the valve body 301. In some embodiments, when the example pressure sensor calibration valve 300 is not in use, a vent port cap 329 may be secured to the valve body 301 to cover and protect the vent port 307. In some embodiments, when the example pressure sensor calibration valve 300 is in use, the vent port cap 329 is removed, and the vent port 307 comprises a vent port opening that can be exposed to the external environment so that the pressure at the vent port 307 is the atmospheric pressure.

Referring back to the example shown in FIG. 3A, the rotatable handle 305 comprises a handle grip 331 and a handle shaft 321.

Similar to the examples described above in connection with FIG. 2A to FIG. 2F, the handle grip 331 is a portion of the rotatable handle 305 that is positioned outside the valve body 301. In some embodiments, a user may place his or her hand to hold the handle grip 331 of the rotatable handle 305 and rotate the rotatable handle 305. In some embodiments, the handle grip 331 is shaped to provide comfort to the user's hand when it grips the handle grip 331. In some embodiments, the handle grip 331 comprises an anti-slip surface so that the user can apply force to rotate the rotatable handle 305 without slipping.

In some embodiments, the handle shaft 321 is a portion of the rotatable handle 305 that is positioned in valve body 301. In some embodiments, the handle shaft 321 may be in a shape similar to an elongated cylindrical shape. In some embodiments, the longitudinal axis of the handle shaft 321 is aligned with a rotational axis of the handle grip 331.

Referring now to FIG. 3B and FIG. 3C, example views of the example pressure sensor calibration valve 300 showing the handle shaft 321 in the valve body 301 are provided. In particular, FIG. 3B illustrates an example cross section back view of the example pressure sensor calibration valve 300, and FIG. 3C illustrates an example zoomed view of the example pressure sensor calibration valve 300.

Similar to the examples described above in connection with FIG. 2A to FIG. 2F, the pressure sensor calibration valve 300 comprises the valve body 301, the rotatable handle 305, and a sealing component 303.

In some embodiments, the sealing component 303 may be in a shape similar to a sphere shape. In some embodiments, the diameter of the sealing component 303 is larger than the diameter of the vent port opening 337 of the vent port 307. In some embodiments, the sealing component 303 may comprise materials such as, but not limited to, silicone, elastomers, plastics, polymers, steel, and and/or the like. In some embodiments, the sealing component 303 may comprise a silicone ball.

In the example shown in FIG. 3B and FIG. 3C, the example pressure sensor calibration valve 300 comprises a leaf spring 333. In some embodiments, the leaf spring 333 comprises a first end and a second end. In some embodiments, the first end is opposite to the second end. In some embodiments, the first end of the leaf spring 333 is secured to an inner surface of vent port 307 of the valve body 301. In some embodiments, the second end of the leaf spring 333 is secured to an outer surface of the sealing component 303.

While the description above provides an example of leaf spring, it is noted that the scope of the present disclosure is not limited to the description above. In some examples, an example pressure sensor calibration valve may comprise one or more additional and/or alternative components (such as, but not limited to, magnetic components) that presses and/or biases the sealing component towards the vent port opening of the vent port.

In some embodiments, the sealing component 303 is connected to a linear rack 309. For example, as shown in FIG. 3B, the sealing component 303 is connected to the linear rack 309 through a connection bridge 335. In some embodiments, the linear rack 309 comprises a plurality of rack teeth 313 that is arranged along a length of the linear rack 309.

In some embodiments, the rotatable handle 305 is connected to a pinion gear 311. For example, as shown in FIG. 3B and FIG. 3C, the handle shaft 321 of the rotatable handle 305 comprises the pinion gear 311. In some embodiments, the pinion gear 311 comprises a plurality of gear teeth 315 that is arranged along an external circumference of the handle shaft 321.

In some embodiments, both the linear rack 309 and the pinion gear 311 are positioned in the valve body 301. For example, both the linear rack 309 and the pinion gear 311 may be positioned in the valve cavity described above. Similar to those described above, the pinion gear 311 engages with the linear rack 309.

FIG. 3B and FIG. 3C illustrate an example position of the sealing component 303 in the example pressure sensor calibration valve 300 when the rotatable handle 305 is in the venting position. As shown in FIG. 3B and FIG. 3C, due to the force exerted on the sealing component 303 through the connection bridge 335, the leaf spring 333 is compressed, and a gap is formed between the sealing component 303 and the vent port opening 337. As such, atmospheric pressure enters the pressure sensor calibration valve 300 through the gap between the sealing component 303 and the vent port opening 337 when the rotatable handle 305 is in the venting position.

In some embodiments, a user may position his or her hand on the handle grip of the rotatable handle and apply force to rotate the rotatable handle from the venting position shown in FIG. 3A to FIG. 3C to the sensing position shown in FIG. 2A to FIG. 2F. As described above, the pinion gear 311 engages with the linear rack 309 such that a rotation of the rotatable handle 305 causes linear movements of the sealing component 303. In some embodiments, the rotation of the rotatable handle 305 may cause a linear movement of the sealing component 303 to be closer to and/or seal the vent port opening 337 of the vent port 307 due to the force exerted on the sealing component 303 through the leaf spring 333.

Referring back to FIG. 3B, the handle shaft 321 may comprise a handle cavity. In some embodiments, the handle cavity is in the form of a center chamber in the handle shaft 321 that serves as a junction connecting different openings of the handle shaft 321. In some embodiments, each opening of the handle shaft 321 is connected to the handle cavity.

In the example, the handle shaft 321 of the rotatable handle 305 comprises a vent opening 323, a sensor opening 325, and a fluid opening 327. In some embodiments, the vent opening 323, the sensor opening 325, and the fluid opening 327 are fluidly connected to one another through the handle cavity.

In some embodiments, when the rotatable handle 305 is at the venting position, the sensor port 317 is fluidly connected to the vent port 307, and the fluid port 319 is fluidly disconnected from the sensor port 317 and the vent port 307.

For example, when the rotatable handle 305 is at the venting position as shown in FIG. 3A to FIG. 3C, the sensor port 317 of the valve body 301 is aligned with the sensor opening 325 of the handle shaft 321, and the vent port 307 of the valve body 301 is aligned with the vent opening 323 of the handle shaft 321. As such, the pressure sensor is fluidly connected to the external environment for atmospheric pressure through the sensor port 317 of the valve body 301 and the sensor opening 325 of the handle shaft 321, through the handle cavity of the handle shaft 321, and through the vent opening 323 of the handle shaft 321 and the vent port 307 of the valve body 301. Because the rotation of the rotatable handle 305 causes the sealing component 303 to be positioned away from the vent port 307, the sealing component 303 no longer seals the vent port opening 337 of the vent port 307 and the vent port 307 is open.

In some embodiments, when the rotatable handle is at the venting position as shown in FIG. 3A to FIG. 3C, the fluid port 319 of the valve body 301 is not aligned with the fluid opening 327 of the handle shaft 321. For example, as shown in FIG. 3B, the fluid opening 327 of the handle shaft 321 is positioned away from the fluid port 319 of the valve body 301. As such, no fluid enters the flow passageway through the fluid port 319 when the rotatable handle 305 is at the venting position.

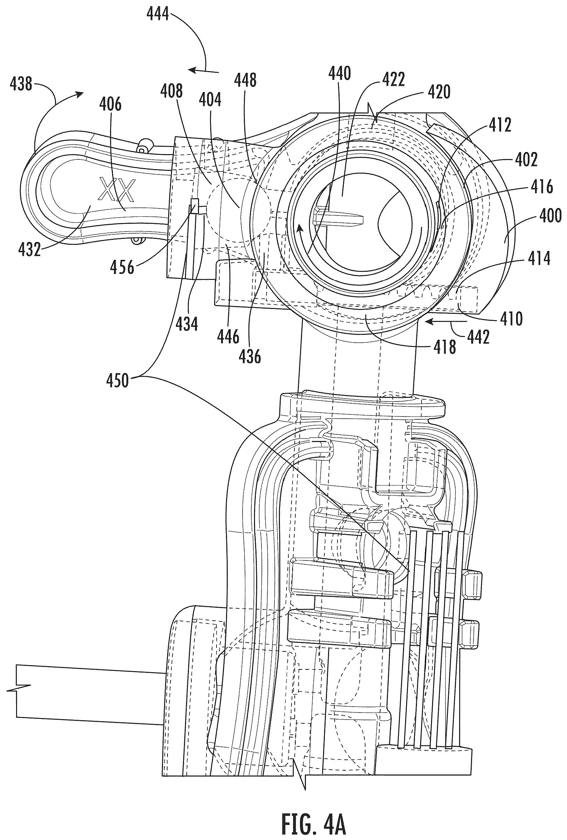

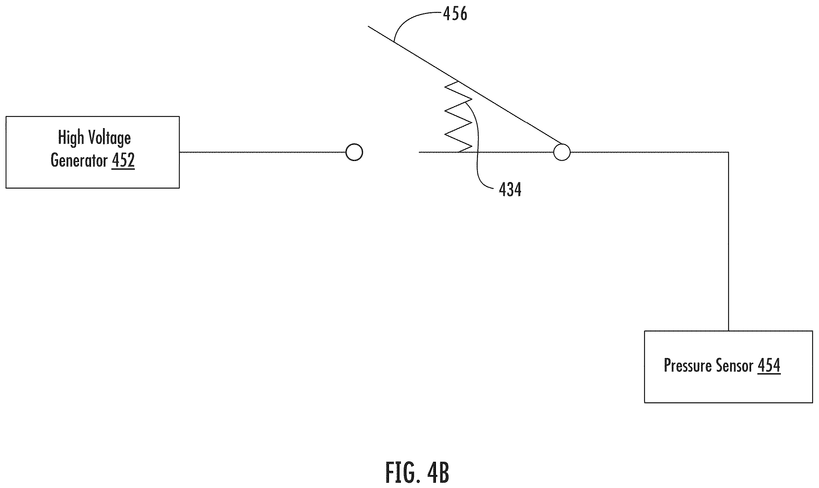

Referring now to FIG. 4A and FIG. 4B, various features of an example pressure sensor calibration valve 400 are illustrated. In particular, FIG. 4A is an example back view illustrating an example pressure sensor calibration valve 400 in accordance with some embodiments of the present disclosure.

It should be noted that certain components in FIG. 4A are illustrated as being transparent or semi-transparent in order to illustrate and highlight various features in accordance with some embodiments of the present disclosure. In some embodiments, such components may be not constructed as transparent or semi-transparent.

In the example shown in FIG. 4A, the pressure sensor calibration valve 400 comprises a valve body 402, a rotatable handle 406, and a sealing component 404.

In some embodiments, the valve body 402 comprises a valve cavity. In some embodiments, the valve cavity is in the form of a center chamber in the valve body 402 that serves as a junction connecting different ports of the valve body 402. In some embodiments, each port of the valve body 402 is connected to the valve cavity and comprises an opening connected to the valve cavity.

For example, the valve body 402 may comprise a fluid port 420, a sensor port 418, and a vent port 408. In such an example, the fluid port 420, the sensor port 418, and the vent port 408 are each connected to the valve cavity of the valve body 402.

In some embodiments, the fluid port 420 is positioned at a top portion of the valve body 402. In some embodiments, the fluid port 420 receives a fluid from the top portion of the valve body 402. For example, in the invasive blood pressure monitoring example described above, the fluid port 420 receives the column of the fluids in the tubing that transfers blood pressure.

In some embodiments, the sensor port 418 is positioned at a bottom portion of the valve body 402. In some embodiments, the sensor port 418 is fluidly connected to a pressure sensor (such as, but not limited to, the example pressure sensor 100 described above in connection with FIG. 1A and FIG. 1B). For example, a tubing connects the sensor port 418 of the valve body 402 to the pressure sensor and provides a fluid passageway from the sensor port 418 to the pressure sensor.

In some embodiments, the vent port 408 is positioned at a side portion of the valve body 402. In some embodiments, the vent port 408 provides a vent port opening that can be exposed to the external environment so that the pressure at the vent port 408 is the atmospheric pressure. In some embodiments, the sealing component 404 may be biased to seal the vent port opening 448 of the vent port 408 when the pressure sensor is not in zeroing calibration.

In some embodiments, the rotatable handle 406 comprises a handle grip 432 and a handle shaft 422.

In some embodiments, the handle grip 432 is a portion of the rotatable handle 406 that is positioned outside the valve body 402. In some embodiments, a user may place his or her hand to hold the handle grip 432 of the rotatable handle 406 and rotate the rotatable handle 406. In some embodiments, the handle grip 432 is shaped to provide comfort to the user's hand when it grips the handle grip 432. In some embodiments, the handle grip 432 comprises an anti-slip surface so that the user can apply force to rotate the rotatable handle 406 without slipping.

In some embodiments, the handle shaft 422 is a portion of the rotatable handle 406 that is positioned in valve body 402. In some embodiments, the handle shaft 422 may be in a shape similar to an elongated cylindrical shape. In some embodiments, the longitudinal axis of the handle shaft 422 is aligned with a rotational axis of the handle grip 432.

In some embodiments, the rotatable handle 406 is rotatable to a plurality of positions. In some embodiments, the plurality of positions of the rotatable handle 406 may comprise a venting position and a sensing position. For example, FIG. 4A illustrates the example rotatable handle 406 at the sensing position.

In some embodiments, a user may position his or her hand on the handle grip of the rotatable handle and apply force to rotate the rotatable handle from the sensing position to the venting position. For example, a user may apply force to rotate the handle grip of the rotatable handle shown in FIG. 4A to switch the rotatable handle from the sensing position to the venting position as shown in FIG. 3A to FIG. 3C.

Similar to various examples described above, when the rotatable handle is at the sensing position, the sensor port is fluidly connected to the fluid port, and the vent port is fluidly disconnected from the sensor port and the fluid port. In some embodiments, when the rotatable handle is at the venting position, the sensor port is fluidly connected to the vent port, and the fluid port is fluidly disconnected from the sensor port and the vent port.

In some embodiments, the sealing component 404 may be in a shape similar to a sphere shape. In some embodiments, the diameter of the sealing component 404 is larger than the diameter of the vent port 408. In some embodiments, the sealing component 404 may comprise materials such as, but not limited to, silicone, elastomers, plastics, polymers, and/or the like. In some embodiments, the sealing component 404 may comprise a silicone ball.

In some embodiments, the sealing component 404 is biased to seal the vent port opening of the vent port 408. In the example shown in FIG. 4A, the example pressure sensor calibration valve 400 comprises a leaf spring 434 that biases the sealing component 404 to the vent port 408.

In some embodiments, the leaf spring 434 comprises a first end and a second end opposite to the first end. In some embodiments, the first end of the leaf spring 434 is secured to an inner surface of vent port 408 of the valve body 402. In some embodiments, the second end of the leaf spring 434 is secured to an outer surface of the sealing component 404. For example, during manufacturing of the example pressure sensor calibration valve 400, the sealing component 404 is positioned in the vent port chamber 446 of the vent port 408. Subsequently, while the leaf spring 434 is compressed, the second end of the leaf spring 434 is secured to the outer surface of the sealing component 404, and the first end of the leaf spring 434 is secured to the inner surface of vent port 408 of the valve body 402. Because the leaf spring 434 has a natural tendency to return to the uncompressed state, the leaf spring 434 exerts force on the sealing component 404 and presses the sealing component 404 against the vent port opening 448 of the vent port 408. As such, the sealing component 404 is biased to cover and seal the vent port opening 448 of the vent port 408 of the valve body 402.

In some embodiments, the sealing component 404 is connected to a linear rack 410. For example, as shown in FIG. 4A, the sealing component 404 is connected to the linear rack 410 through a connection bridge 436. In some embodiments, the linear rack 410 comprises a plurality of rack teeth 414 that is arranged along a length of the linear rack 410.

In some embodiments, the rotatable handle 406 is connected to a pinion gear 412. For example, as shown in FIG. 4A, the handle shaft 422 of the rotatable handle 406 is connected to the pinion gear 412. In some embodiments, the pinion gear 412 comprises a plurality of gear teeth 416 that is arranged along a circumference of the pinion gear 412.

In some embodiments, both the linear rack 410 and the pinion gear 412 are positioned in the valve body 402. For example, both the linear rack 410 and the pinion gear 412 may be positioned in the valve cavity described above.

In some embodiments, the pinion gear 412 engages with the linear rack 410 such that a rotation of the rotatable handle 406 causes a displacement of the sealing component 404 away from the vent port opening of the vent port 408.

For example, as shown in FIG. 4A, a rotation of the rotatable handle 406 in the direction as shown by the arrow 438 causes a rotation of the plurality of gear teeth 416 of the pinion gear 412 in the direction as shown by the arrow 440. In some embodiments, the plurality of gear teeth 416 of the pinion gear 412 engages with the plurality of rack teeth 414 of the linear rack 410. As such, the rotation of the plurality of gear teeth 416 in the direction as shown by the arrow 440 causes a linear movement of the linear rack 410 in the direction as shown by the arrow 442. Continuing in this example, the linear movement of the linear rack 410 in the direction as shown by the arrow 442 exerts a force on the sealing component 404 in the direction as shown by the arrow 444 because the sealing component 404 is connected to the linear rack 410 through the connection bridge 436. In some embodiments, the force exerted on the sealing component 404 by the linear rack 410 through the connection bridge 436 compresses the leaf spring 434 and causes the sealing component 404 to be pushed away from the vent port opening 448 of the vent port 408. As such, the vent port opening 448 is unsealed.

In some embodiments, a spring-actuated switch 456 is coupled with the leaf spring 434. In some embodiments, the spring-actuated switch 456 is a type of switch that operates based on the compression state of the leaf spring 234. Referring now to FIG. 4B, an example circuit diagram illustrating example electronic components of the example pressure sensor calibration valve 400 (including the spring-actuated switch 456 and the leaf spring 234) shown in FIG. 4A is provided,

In the example shown in FIG. 4B, the spring-actuated switch 456 is electronically coupled to a pressure sensor 454 (for example, through one or more cable wires 450 shown in FIG. 4A). In some embodiments, when the leaf spring 434 is compressed as a result of the rotatable handle 406 rotating from the sensing position to the venting position, the spring-actuated switch 456 is activated and switched on so that the contact of the spring-actuated switch 456 electrically couples the high voltage generator 452 to the pressure sensor 454 (or other electronic component that is coupled to the pressure sensor 454 as described below). In some embodiments, the high voltage generator 452 transmits a high voltage signal to the pressure sensor 454 (or other electronic component that is coupled to the pressure sensor 454 as described below) that triggers the pressure sensor 454 to initiate the zeroing calibration process.

As such, the rotation of the rotatable handle from the sensing position to a venting position not only causes a displacement of the sealing component 404 away from the vent port opening 448 (and therefore enables the pressure sensor 454 to detect atomistic pressure), but also triggers an electrical signal (as the spring-actuated switch 456 is turned on and transmits the voltage signal from the high voltage generator 452) that initiates the zeroing calibration of the pressure sensor 454. As such, an example pressure sensor calibration valve in accordance with some embodiments of the present disclosure improves zeroing calibration of pressure sensors.

While FIG. 4B illustrates an example where the electrical signal is transmitted to the pressure sensor 454, it is noted that the scope of the present disclosure is not limited to the description above. For example, one or more electronic components may also be electronically coupled to the pressure sensor 454 (such as, but not limited to, a sensor controller). In such an example, the spring-actuated switch 456 is electronically coupled to the sensor controller. When the rotatable handle is rotated from the sensing position to the venting position, the spring-actuated switch 456 is switched on so that so that a high voltage signal is provided to the sensor controller, and the sensor controller in turn initiates the zeroing calibration of the pressure sensor 454.

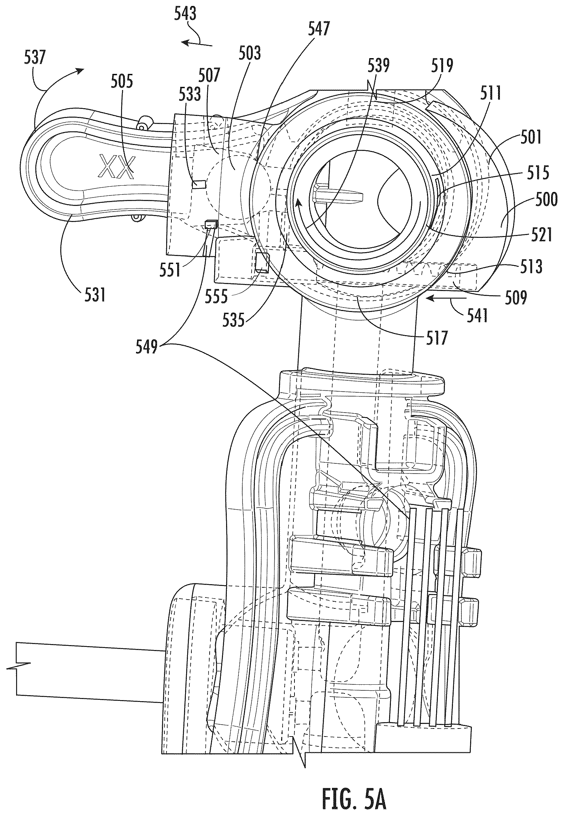

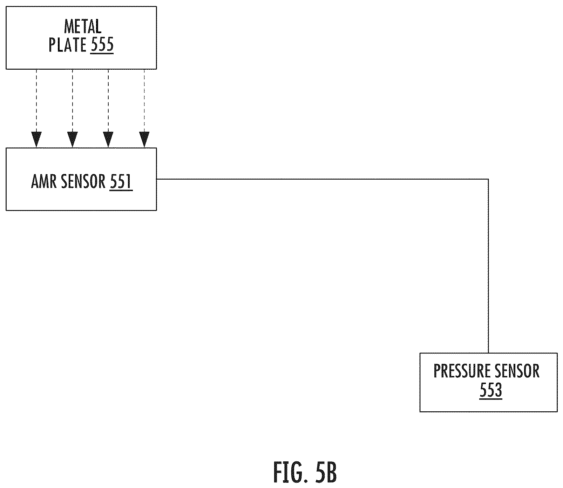

Referring now to FIG. 5A and FIG. 5B, various features of an example pressure sensor calibration valve 500 are illustrated. In particular, FIG. 5A is an example back view illustrating an example pressure sensor calibration valve 500 in accordance with some embodiments of the present disclosure.

It should be noted that certain components in FIG. 5A are illustrated as being transparent or semi-transparent in order to illustrate and highlight various features in accordance with some embodiments of the present disclosure. In some embodiments, such components may be not constructed as transparent or semi-transparent.

In the example shown in FIG. 5A, the pressure sensor calibration valve 500 comprises a valve body 501, a rotatable handle 505, and a sealing component 503.

In some embodiments, the valve body 501 comprises a valve cavity. In some embodiments, the valve cavity is in the form of a center chamber in the valve body 501 that serves as a junction connecting different ports of the valve body 501. In some embodiments, each port of the valve body 501 is connected to the valve cavity and comprises an opening connected to the valve cavity.

For example, the valve body 501 may comprise a fluid port 519, a sensor port 517, and a vent port 507. In such an example, the fluid port 519, the sensor port 517, and the vent port 507 are each connected to the valve cavity of the valve body 501.

In some embodiments, the fluid port 519 is positioned at a top portion of the valve body 501. In some embodiments, the fluid port 519 receives a fluid from the top portion of the valve body 501. For example, in the invasive blood pressure monitoring example described above, the fluid port 519 receives the column of the fluids in the tubing that transfers blood pressure.

In some embodiments, the sensor port 517 is positioned at a bottom portion of the valve body 501. In some embodiments, the sensor port 517 is fluidly connected to a pressure sensor (such as, but not limited to, the example pressure sensor 100 described above in connection with FIG. 1A and FIG. 1B). For example, a tubing connects the sensor port 517 of the valve body 501 to the pressure sensor and provides a fluid passageway from the sensor port 517 to the pressure sensor.

In some embodiments, the vent port 507 is positioned at a side portion of the valve body 501. In some embodiments, the vent port 507 provides an opening that can be exposed to the external environment so that the pressure at the vent port 507 is the atmospheric pressure. In some embodiments, the sealing component 503 may be biased to seal the vent port opening of the vent port 507 when the pressure sensor is not in zeroing calibration.

In some embodiments, the rotatable handle 505 comprises a handle grip 531 and a handle shaft 521.

In some embodiments, the handle grip 531 is a portion of the rotatable handle 505 that is positioned outside the valve body 501. In some embodiments, a user may place his or her hand to hold the handle grip 531 of the rotatable handle 505 and rotate the rotatable handle 505. In some embodiments, the handle grip 531 is shaped to provide comfort to the user's hand when it grips the handle grip 531. In some embodiments, the handle grip 531 comprises an anti-slip surface so that the user can apply force to rotate the rotatable handle 505 without slipping.

In some embodiments, the handle shaft 521 is a portion of the rotatable handle 505 that is positioned in valve body 501. In some embodiments, the handle shaft 521 may be in a shape similar to an elongated cylindrical shape. In some embodiments, the longitudinal axis of the handle shaft 521 is aligned with a rotational axis of the handle grip 531.

In some embodiments, the rotatable handle 505 is rotatable to a plurality of positions. In some embodiments, the plurality of positions of the rotatable handle 505 may comprise a venting position and a sensing position. For example, FIG. 5A illustrates the example rotatable handle 505 at the sensing position.

In some embodiments, a user may position his or her hand on the handle grip of the rotatable handle and apply force to rotate the rotatable handle from the sensing position to the venting position. For example, a user may apply force to rotate the handle grip of the rotatable handle shown in FIG. 5A switch the rotatable handle from the sensing position to the venting position as shown in FIG. 3A to FIG. 3C.

Similar to various examples described above, when the rotatable handle is at the sensing position, the sensor port is fluidly connected to the fluid port, and the vent port is fluidly disconnected from the sensor port and the fluid port. In some embodiments, when the rotatable handle is at the venting position, the sensor port is fluidly connected to the vent port, and the fluid port is fluidly disconnected from the sensor port and the vent port.

In some embodiments, the sealing component 503 may be in a shape similar to a sphere shape. In some embodiments, the diameter of the sealing component 503 is larger than the diameter of the vent port 507. In some embodiments, the sealing component 503 may comprise materials such as, but not limited to, silicone, elastomers, plastics, polymers, steel, and/or the like. In some embodiments, the sealing component 503 may comprise a silicone ball.

In some embodiments, the sealing component 503 is biased to seal the vent port opening of the vent port 507. In some embodiments, the sealing component 503 is biased to seal the vent port opening of the vent port 507 through a leaf spring

In some embodiments, the leaf spring 533 comprises a first end and a second end opposite to the first end. In some embodiments, the first end of the leaf spring 533 is secured to an inner surface of vent port 507 of the valve body 501. In some embodiments, the second end of the leaf spring 533 is secured to an outer surface of the sealing component 503. For example, during manufacturing of the example pressure sensor calibration valve 500, the sealing component 503 is positioned in the vent port chamber of the vent port 507. Subsequently, while the leaf spring 533 is compressed, the second end of the leaf spring 533 is secured to the outer surface of the sealing component 503, and the first end of the leaf spring 533 is secured to the inner surface of vent port 507 of the valve body 501. Because the leaf spring 533 has a natural tendency to return to the uncompressed state, the leaf spring 533 exerts force on the sealing component 503 and presses the sealing component 503 against the vent port opening 547 of the vent port 507. As such, the sealing component 503 is biased to cover and seal the vent port opening 547 of the vent port 507 of the valve body 501.

In some embodiments, the sealing component 503 is connected to a linear rack 509. For example, as shown in FIG. 5A, the sealing component 503 is connected to the linear rack 509 through a connection bridge 535. In some embodiments, the linear rack 509 comprises a plurality of rack teeth 513 that is arranged along a length of the linear rack 509.

In some embodiments, the rotatable handle 505 is connected to a pinion gear 511. For example, as shown in FIG. 5A, the handle shaft 521 of the rotatable handle 505 is connected to the pinion gear 511. In some embodiments, the pinion gear 511 comprises a plurality of gear teeth 515 that is arranged along a circumference of the pinion gear 511.

In some embodiments, both the linear rack 509 and the pinion gear 511 are positioned in the valve body 501. For example, both the linear rack 509 and the pinion gear 511 may be positioned in the valve cavity described above.

In some embodiments, the pinion gear 511 engages with the linear rack 509 such that a rotation of the rotatable handle 505 causes a displacement of the sealing component 503 away from the vent port opening of the vent port 507.

For example, as shown in FIG. 5A, a rotation of the rotatable handle 505 in the direction as shown by the arrow 537 causes a rotation of the plurality of gear teeth 515 of the pinion gear 511 in the direction as shown by the arrow 539. In some embodiments, the plurality of gear teeth 515 of the pinion gear 511 engages with the plurality of rack teeth 513 of the linear rack 509. As such, the rotation of the plurality of gear teeth 515 in the direction as shown by the arrow 539 causes a linear movement of the linear rack 509 in the direction as shown by the arrow 541. Continuing in this example, the linear movement of the linear rack 509 in the direction as shown by the arrow 541 exerts a force on the sealing component 503 in the direction as shown by the arrow 543 because the sealing component 503 is connected to the linear rack 509 through the connection bridge 535. In some embodiments, the force exerted on the sealing component 503 by the linear rack 509 through the connection bridge 535 compresses the leaf spring 533 and causes the sealing component 503 to be pushed away from the vent port opening 547 of the vent port 507. As such, the vent port opening 547 is unsealed.

In some embodiments, the pressure sensor calibration valve 500 further comprises a metal plate 555 and an anisotropic magnetresistance (AMR) sensor 551 that detects the linear movement of the linear rack 509 in order to trigger an electrical signal that initiates the zeroing calibration of the pressure sensor as a result of a rotation of the rotatable handle 505 from the sensing position to a venting position.

In the example shown in FIG. 5A, the metal plate 555 is secured to an end of the linear rack 509 (for example, disposed on the end surface of the linear rack 509 or embedded at the end of the linear rack 509). In some embodiments, the metal plate 555 comprises metal material. As such, a rotation of the rotatable handle 505 causes a linear movement of the metal plate 555 as a part of the linear rack 509.

While the description above provides an example metal plate 555 being positioned at the end of the linear rack 509, it is noted that the scope of the present disclosure is not limited to the description above. Additionally, or alternatively, a metal plate may be secured on the handle shaft 521 (for example, disposed on a surface of the handle shaft 521 or embedded in the handle shaft 521). In such an example, a rotation of the rotatable handle 505 causes a rotational movement of the metal plate as a part of the handle shaft 521.

In some embodiments, the AMR sensor 551 is secured in the valve body 501. In some embodiments, the AMR sensor 551 is configured to detect changes in the magnetic field as a result of linear and/or rotational movements of the metal plate 555 . In some embodiments, upon detecting the linear and/or rotational movements of the metal plate 555 , the AMR sensor 551 is triggered to generate an electrical signal that initiates the zeroing calibration of a pressure sensor (additional details are described in connection with FIG. 5B).

In some embodiments, the pressure sensor calibration valve 500 may further comprise a biasing magnet that is secured in the valve body 501 and adjacent to the AMR sensor 551 to enhance the detection sensitivity of the AMR sensor 551.

Referring now to FIG. 5B, an example circuit diagram illustrating example electronic components of the example pressure sensor calibration valve 500 shown in FIG. 5A is provided.

In the example shown in FIG. 5B, the AMR sensor 551 is electronically coupled to a pressure sensor 553 (for example, through one or more cable wires 549 shown in FIG. 5A). In some embodiments, a rotation of the rotatable handle 505 from the sensing position to the venting position causes a movement of the metal plate 555, and the movement of the metal plate 555 is detected by the AMR sensor 551. In some embodiments, upon detecting the movement of the metal plate 555 as a result of the rotation of the rotatable handle 505 to the venting position, the AMR sensor 551 generates an electrical signal that initiates the zeroing calibration of the pressure sensor 553.

As such, the rotation of the rotatable handle from the sensing position to a venting position not only causes a displacement of the sealing component 503 away from the vent port opening 547 (and therefore enables the pressure sensor 553 to detect atomistic pressure), but also triggers an electrical signal that initiates the zeroing calibration of the pressure sensor 553. As such, an example pressure sensor calibration valve in accordance with some embodiments of the present disclosure improves zeroing calibration of pressure sensors.

While FIG. 5B illustrates an example where the electrical signal is transmitted to the pressure sensor 553, it is noted that the scope of the present disclosure is not limited to the description above. For example, one or more electronic components may also be electronically coupled to the pressure sensor 553 (such as, but not limited to, a sensor controller). In such an example, the AMR sensor 551 is electronically coupled to the sensor controller. When the rotatable handle is rotated from the sensing position to the venting position, the AMR sensor 551 transmits an electrical signal to the sensor controller, and the sensor controller in turn initiates the zeroing calibration of the pressure sensor 553.

It is to be understood that the disclosure is not to be limited to the specific embodiments disclosed, and that modifications and other embodiments are intended to be included within the scope of the appended claims. Although specific terms are employed herein, they are used in a generic and descriptive sense only and not for purposes of limitation, unless described otherwise.

## Claims

1. A pressure sensor calibration valve for improving zeroing calibration of a pressure sensor comprising:
a valve body comprising a vent port;
a rotatable handle connected to a pinion gear positioned in the valve body, and
a sealing component connected to a linear rack that engages with the pinion gear, the sealing component being biased to seal a vent port opening of the vent port when the rotatable handle is at a sensing position,
wherein a rotation of the rotatable handle from the sensing position to a venting position causes a displacement of the sealing component away from the vent port opening and triggers an electrical signal that initiates the zeroing calibration of the pressure sensor.

2. The pressure sensor calibration valve of claim 1, wherein the electrical signal is transmitted to the pressure sensor.

3. The pressure sensor calibration valve of claim 1, wherein the electrical signal is transmitted to a sensor controller that is electrically coupled to the pressure sensor.

4. The pressure sensor calibration valve of claim 1, wherein the sealing component is biased to seal the vent port opening of the vent port by a leaf spring.

5. The pressure sensor calibration valve of claim 4, wherein the leaf spring is coupled to a spring-actuated switch, wherein the rotation of the rotatable handle from the sensing position to the venting position activates the spring-actuated switch.

6. The pressure sensor calibration valve of claim 1, further comprising:
a metal plate secured to an end of the linear rack; and
an anisotropic magnetresistance (AMR) sensor secured in the valve body.

7. The pressure sensor calibration valve of claim 6, wherein the rotation of the rotatable handle from the sensing position to the venting position causes a linear movement of the metal plate that triggers the AMR sensor to generate the electrical signal.

8. The pressure sensor calibration valve of claim 1, wherein the linear rack comprises a plurality of rack teeth, wherein the pinion gear comprises a plurality of gear teeth, wherein the plurality of gear teeth engages with the plurality of rack teeth.

9. The pressure sensor calibration valve of claim 8, wherein the rotation of the rotatable handle causes a rotation of the plurality of gear teeth, wherein the rotation of the plurality of gear teeth causes a linear movement of the linear rack and the sealing component.

10. The pressure sensor calibration valve of claim 1, wherein the valve body further comprises a sensor port and a fluid port.

11. The pressure sensor calibration valve of claim 10, wherein the fluid port receives a fluid.

12. The pressure sensor calibration valve of claim 10, wherein the sensor port is fluidly connected to the pressure sensor.

13. The pressure sensor calibration valve of claim 10, wherein the rotatable handle comprises a handle shaft positioned in the valve body, wherein the pinion gear is connected to the handle shaft.

14. The pressure sensor calibration valve of claim 13, wherein the handle shaft comprises a vent opening, a sensor opening, and a fluid opening, wherein the vent opening, the sensor opening, and the fluid opening are fluidly connected to one another.

15. The pressure sensor calibration valve of claim 14, wherein, when the rotatable handle is at the venting position, the sensor port is fluidly connected to the vent port, and the fluid port is fluidly disconnected from the sensor port and the vent port.
